# EUROPEAN PATENT SPECIFICATION

(11) **EP 1 542 516 B1**
(45) Date of publication and mention of the grant of the patent: **14.12.2005**
(21) Application number: 03257696.9
(22) Date of filing: 08.12.2003
(51) Int. Cl.: H05K 1/02, H05K 7/20

(54) **Heat dissipating microdevice and method of making the same**
Mikrovorrichtung zur Wärmeabfuhr und deren Herstellungsverfahren
Microdispositif pour dissiper la chaleur et sa méthode de fabrication

(43) Date of publication of application: 15.06.2005
(73) Proprietor: Asia Vital Component Co., Ltd.,, Chien Chen Kaoshiung City (TW)
(72) Inventor: Lee, Chang-Chi, Nei-Hu District Taipei City (TW); Ding, Pei-Pei, Hsin-Chuang City Taipei Hsien (TW); Lin, Jao-Ching, Hsin-Chuang City Taipei Hsien (TW)
(74) Representative: Rees, Alexander Ellison

(56) References cited:
- DE-A- 19 739 722
- US-A- 5 316 077
- US-A- 5 763 951
- US-A1- 2002 062 648

## Description

The invention relates to a heat dissipating micro device, more particularly to a heat dissipating micro device including a fluid microsystem formed in an insulator layer of a board.

In German Patent Nos. DE19739719 and DE19739722, there is disclosed a conventional method of making a hollow microstructure using first and second circuit boards. Each of the first and second circuit boards includes an insulator layer that has first and second surfaces, and a conductor layer formed on the first surface of the insulator layer. The method comprises the steps of forming recesses in the conductor layer of the first circuit board and bonding the second surface of the insulator layer of the second circuit board on the conductor layer of the first circuit board to form the hollow microstructure. Although the method proposed therein permits hollow microstructure fabrication, since the resulting hollow microstructure is disposed in between the insulator layers, it is not suitable for heat dissipating applications.

A known heat dissipating device is disclosed in US2002/0062648A1. This discloses a heat dissipating microdevice comprising a number of heat pipe microstructures formed between two substrates. The heat pipes extend between hot and cold regions of the device to allow heat dissipation.

Therefore, the object of the present invention is to provide a heat dissipating microdevice that includes a fluid microsystem formed in an insulator layer of a board and that is applicable for absorbing and dissipating heat.

Another object of the present invention is to provide a method of making the invention heat dissipating midrodevice.

According to one aspect of the present invention, a heat dissipating microdevice characterized by:
a board including an insulator layer that has a first surface and a second surface opposite to said first surface in
a first direction, a conductor layer formed on said first surface, and a cover member disposed on said second surface, said board having a first area and a second area opposite to said first area in a second direction transverse to the first direction, said first area being adapted to be placed in thermal contact with a heat source;
a fluid microsystem formed in said insulator layer of said board, and including
   first and second micro-channel structures disposed respectively in said first and second areas of said board, at least one of said first and second micro-channel structures being bounded by at least one of said conductor layer and said cover member,
   first and second micro-conduit structures that permit fluid communication between said first and second micro-channel structures, said first micro-conduit structure including a first end section in fluid communication with said second micro-channel structure and a second end section extending to and in fluid communication with said first micro-channel structure, said second micro-conduit structure including a first end section in fluid communication with said first micro-channel structure and a second end section extending to and in fluid communication with said second micro-channel structure, and
   a receiving microstructure that is disposed between and that permits fluid communication between said first micro-channel structure and said second micro-conduit structure, that includes a first end portion extending to and in fluid communication with said first micro-channel structure and a second end portion extending to and in fluid communication with said first end section of said second micro-conduit structure, and that has a cross-section larger than those of said first micro-channel structure and said second micro-conduit structure; and
a coolant contained in said fluid microsystem, said coolant flowing from said second micro-channel structure to said first micro-channel structure through said first micro-conduit structure, and from said first micro-channel structure back to said second micro-channel structure through said second micro-conduit structure and said receiving microstructure.

According to another aspect of the present invention, a method of making a heat dissipating microdevice, characterized by the steps of:
(a) providing a board that includes an insulator layer having a first surface and a second surface opposite to the first surface, and a conductor layer formed on the first surface of the insulator layer;
(b) forming a hole unit in said insulator layer that extends from the first surface to the second surface of the insulator layer to result in a fluid microsystem, the fluid microsystem including
   first and second micro-channel structures disposed respectively in first and second areas of the board and bounded by the conductor layer,
   first and second micro-conduit structures that permit fluid communication between the first and second micro-channel structures, the first micro-conduit structure including a first end section in fluid communication with the second micro-channel structure and a second end section extending to and in fluid communication with the first micro-channel structure, the second micro-conduit structure including a first end section in fluid communication with the first micro-channel structure and a second end section extending to and in fluid communication with the second micro-channel structure, and
   a receiving microstructure that is disposed between and that permits fluid communication between the first micro-channel structure and the second micro-conduit structure, that
   includes a first end portion extending to and in fluid communication with the first micro-channel structure and a second end portion extending to and in fluid communication with the first end section of the second micro-conduit structure, and that has a cross-section larger than those of the first micro-channel structure and the second micro-conduit structure;
   disposing a cover member on the second surface of the insulator layer; and
(d) filling the fluid microsystem with a coolant.
   Other features and advantages of the present invention will become apparent in the following detailed description of the preferred embodiments with referenced to the accompanying drawings, of which:
   Figure 1 is a schematic view of the first preferred embodiment of a heat dissipating microdevice according to this invention;
   Figure 2 is a schematic view to illustrate a board of the preferred embodiment;
   Figure 3 is a schematic view of the second preferred embodiment of a heat dissipating microdevice according to this invention;
   Figure 4 is a schematic view of the third preferred embodiment of a heat dissipating microdevice according to this invention;
   Figure 5 is a fragmentary sectional viewto illustrate a metallic grid microstructure disposed in a first micro-channel structure;
   Figure 6 is a fragmentary sectional view to illustrate a plurality of capillary protrusions formed in the first micro-channel structure;
   Figure 7 is a fragmentary sectional view of the fourth preferred embodiment of a heat dissipating microdevice according to this invention;
   Figure 8 is a flowchart of the first preferred embodiment of a method of making the heat dissipating microdevice according to the present invention;
   Figure 9 is a fragmentary sectional view to illustrate a board having an insulator layer, and a conductor layer prepared according to the method of the first preferred embodiment;
   Figure 10 is a fragmentary sectional view to illustrate how the insulator layer of the board of Figure 9 is patterned in the method of the first preferred embodiment;
   Figure 11 is a fragmentary sectional view to illustrate how a hole unit is formed in the insulator layer of the board of Figure 10 according to the method of the first preferred embodiment;
   Figure 12 is a fragmentary sectional view to illustrate how a cover member is disposed on the insulator layer of the board of Figure 11 according to the method of the first preferred embodiment;
   Figure 13 is a flowchart of the second preferred embodiment of a method of making the heat dissipating microdevice according to the present invention;
   Figure 14 is a fragmentary sectional view to illustrate a board having an insulator layer, and a conductor layer prepared according to the method of the second preferred embodiment;
   Figure 15 is a fragmentary sectional view to illustrate how the insulator layer of the board of Figure 14 is patterned in the method of the second preferred embodiment;
   Figure 16 is a fragmentary sectional view to illustrate how a first hole unit is formed in the insulator layer of the board of Figure 15 according to the method of the second preferred embodiment;
   Figure 17 is a fragmentary sectional view to illustrate how a cover member is disposed on the insulator layer of the board of Figure 16 according to the method of the second preferred embodiment;
   Figure 18 is a fragmentary sectional view to illustrate how a communicating hole unit is formed in the cover member of Figure 17 according to the method of the second preferred embodiment;
   Figure 19 is a fragmentary sectional view to illustrate an insulator layer disposed on the cover member of Figure 18 according to the method of the second preferred embodiment;
   Figure 20 is a fragmentary sectional view to illustrate how the insulator layer of Figure 19 is patterned in the method of the second preferred embodiment;
   Figure 21 is a fragmentary sectional view to illustrate how a second hole unit is formed in the insulator layer of Figure 20 according to the method of the second preferred embodiment;
   Figure 22 is a fragmentary sectional view to illustrate how a metallic grid microstructure is disposed in a first micro-channel structure according to the method of the second preferred embodiment; and
   Figure 23 is a fragmentary sectional view to illustrate a covermember disposed on the insulator layer to cover the first micro-channel structure of Figure 22 according to the method of the second preferred embodiment.

Before the present invention is described in greater detail, it should be noted that like elements are denoted by the same reference numerals throughout the disclosure.

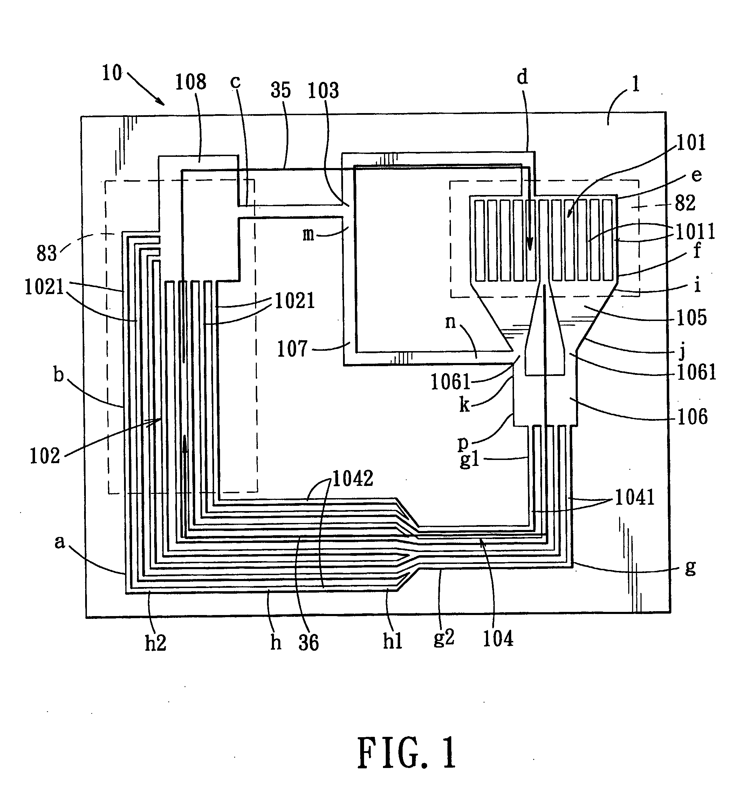

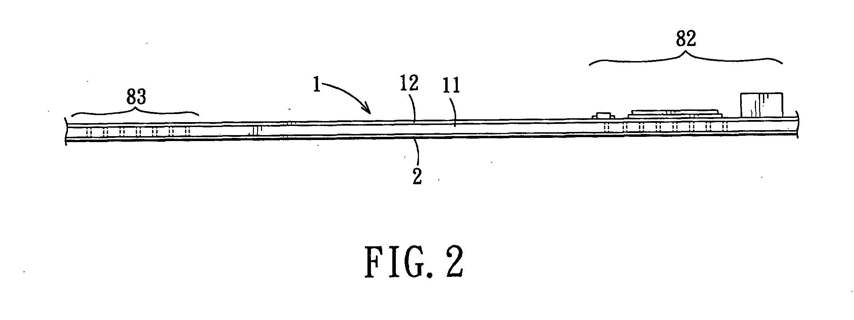

Referring to Figures 1 and 2, the first preferred embodiment of a heat dissipating microdevice according to this invention is shown to include a board 1, a fluid microsystem 10, and a coolant.

The board 1 includes a first insulator layer 11 that has a first surface and a second surface opposite to the first surface in a first direction, a first conductor layer 12 formed on the first surface, and a cover member 2 disposed on the second surface. The board 1 has a first area 82 and a second area 83 opposite to the first area 82 in a second direction transverse to the first direction. The first area 82 is adapted to be placed in thermal contact with a heat source (not shown) . Preferably, the first insulator layer 11 is made from epoxy resin. Moreover, the cover member 2 is preferably made of a material the same as that of the first conductor layer 12. Alternatively, the cover member 2 may be made of a material the same as that of the first insulator layer 11 or glass. Further, the heat source is preferably an electronic component, such as an integrated circuit (IC) .

The fluid microsystem 10 includes first and second micro-channel structures 101, 102 that are disposed respectively in the first and second areas 82, 83 of the board 1, and first and second micro-conduit structures 103, 104 that permit fluid communication between the first and second micro-channel structures 101, 102.

The coolant is contained in the fluid microsystem 10. As indicated by arrow 35, the coolant flows from the second micro-channel structure 102 to the first micro-channel structure 101 through the first micro-conduit structure 103, and, as indicated by arrow 36, from the first micro-channel structure 101 back to the second micro-channel structure 102 through the second micro-conduit structure 104. Preferably, the coolant is distilled water. Alternatively, the coolant can be one of de-ionized water, methanol, and acetone.

The preferred configuration of the fluid microsystem 10 will be described in greater detail in the succeeding paragraphs.

Each of the first and second micro-channel structures 101, 102 includes a plurality of parallel channels 1011, 1021, each of which includes first and second endportions (e), (a), (f), (b) .

Each of the first and second micro-conduit structures 103, 104 includes first and second end sections (c), (g), (d), (h). The first end section (c) of the first micro-conduit structure 103 is in fluid communication with the second end portions (b) of the channels 1021 of the second micro-channel structure 102. The second end section (d) of the first micro-conduit structure 103 extends to and is in fluid communication with the first end portions (e) of the channels 1011 of the first micro-channel structure 101. The first end section (g) of the second micro-conduit structure 104 includes a plurality of parallel first conduits 1041, each of which has first and second end portions (g1), (g2). The first end portion (g1) of each of the first conduits 1041 is in fluid communication with the channels 1011 of the first micro-channel structure 101. The second end portion (g2) of each of the first conduits 1041 is bifurcated to form a pair of branches. The second end section (h) of the second micro-conduit structure 104 includes a plurality of parallel second conduits 1042, each of which has first and second end portions (h1), (h2) . The first end portion (h1) of each of the second conduits 1042 extends from one of the branches of a respective one of the first conduits 1041. The second end portion (h2) of the second conduits 1042 extends to and is in fluid communication with the first end portion (a) of a respective one of the channels 1021 of the second micro-channel structure 102.

The fluid microsystem 10 further includes a receiving microstructure 105 that is disposed between and that permits fluid communication between the first micro-channel structure 101 and the second micro-conduit structure 104, and that includes first and second end portions (i), (j). In this embodiment, the receiving microstructure 105 has a diverging section that serves as the first end portion (i), and a converging section that serves as the second end portion (j) . The first end portion (i) of the receiving microstructure 105 extends to and is in fluid communication with the first micro-channel structure 101, i.e. , the second end portions (f) of the channels 1011 of the first micro-channel structure 101 extend to the first end portion (i) of the receiving microstructure 105.

The fluid microsystem 10 further includes a mixing microstructure 106 that is disposed between and that permits fluid communication between the receiving microstructure 105 and the second micro-conduit structure 104, and that includes first and second end portions (k), (p). In this embodiment, the first end portion (k) of the mixing microstructure 106 includes a pair of micro-passage structures 1061 that extend to and that are in fluid communication with the second end portion (j) of the receiving microstructure 105. The second end portion (p) of the mixing microstructure 106 extends to and is in fluid communication with the first end section (g) of the second micro-conduit structure 104, i.e., the first end portions (g1) of the first conduits 1041 of the first end section (g) of the second micro-conduit structure 104 extend to and are in fluid communication with the second end portion (p) of the mixing microstructure 106.

The fluid microsystem 10 further includes a third micro-conduit structure 107 that is disposed between and that permits fluid communication between the first micro-conduit structure 103 and the mixing microstructure 106, and that includes first and second end portions (m), (n). In this embodiment, the first end portion (m) of the third micro-conduit structure 107 extends to the first end section (c) of the first micro-conduit structure 103. The second end portion (n) of the third micro-conduit structure 107 extends to one of the micro-passage structures 1061 of the first end portion (k) of the mixing microstructure 106. The construction as such permits the coolant to flow from the second micro-channel structure 102 to the mixing microstructure 106 through the third micro-conduit structure 107 without passing through the first micro-channel structure 101. In an alternative embodiment, the fluid microsystem 10 is dispensed with both the mixing microstructure 106 and the third micro-conduit structure 107.

The fluid microsystem 10 further includes a micro-reservoir structure 108 that is disposed between and that is in fluid communication with the second micro-channel structure 102 and the first micro-conduit structure 103. In this embodiment, the channels 1021 of the second micro-channel structure 102 extend between the micro-reservoir structure 108 and a respective one of the second end portions (h2) of the second conduits 1042 of the second section (h) of the secondmicro-conduit structure 104. The first end portion (c) of the first micro-conduit structure 103 extends to and is in fluid communication with the micro-reservoir structure 108.

It is noted that each of the first conduits 1041 has a cross-section larger than that of each of the second conduits 1042. As such, the second end section (h) of the second micro-conduit structure 104 has a capillary effect that is greater than that of the first end section (g) of the second micro-conduit structure 104. Moreover, the micro-reservoir structure 108 has a cross-section larger than those of each of the channels 1021 of the second micro-channel structure 102 and the first micro-conduit structure 103. As such, the coolant flowing from the second micro-channel structure 102 to the first micro-channel structure 101 through the first micro-conduit structure 103 is first accumulated in the micro-reservoir structure 108. Further, the receiving microstructure 105 has a largest cross-section larger than those of each of the channels 1011 of the first micro-channel structure 101, each of the first and second conduits 1041, 1042 of the second micro-conduit structure 104, and that of the mixing microstructure 106.

In the preferred embodiment, the fluid microsystem 10 is bounded by both the first conductor layer 12 and the cover member 2. This will become apparent in the succeeding paragraphs.

It is further noted that the number of channels 1011 of the first micro-channel structure 101 can be made as many as possible so as to maximize contact area between the first micro-channel structure 101 and the first conductor layer 12.

In use, when the heat dissipating microdevice is disposed such that the first area 82 is in thermal contact with the heat source, the coolant in the first micro-channel structure 101 absorbs heat generated by the heat source. Once the coolant in the first micro-channel structure 101 reaches its boiling point, it quickly vaporizes. As soon as the coolant vaporizes, the vaporized coolant starts flowing to the receiving microstructure 105. Consequently, the coolant in the first micro-conduit structure 103 flows to the first micro-channel structure 101, the coolant in the micro-reservoir structure 108 flows to the first micro-conduit structure 103, and the coolant in the second micro-channel structure 102 flows to the micro-reservoir structure 108. At this time, the vaporized coolant flows through the receiving microstructure 105 at an increasing speed. By the time the vaporized coolant reaches the mixing microstructure 106, the vaporized coolant flows substantially a very high speed, thus creating a low pressure level in the mixing microstructure 106. Accordingly, the coolant in the third micro-conduit structure 107 is drawn into the mixing microstructure 106. Subsequently, the vaporized coolant mixes and exchanges heat with the coolant from the third micro-conduit structure 107 by convection, is cooled considerably, and condenses. The mixed coolant then flows to the second micro-conduit structure 104 and, finally, to the second micro-channel structure 102. By this time, the absorbed heat is completely dissipated.

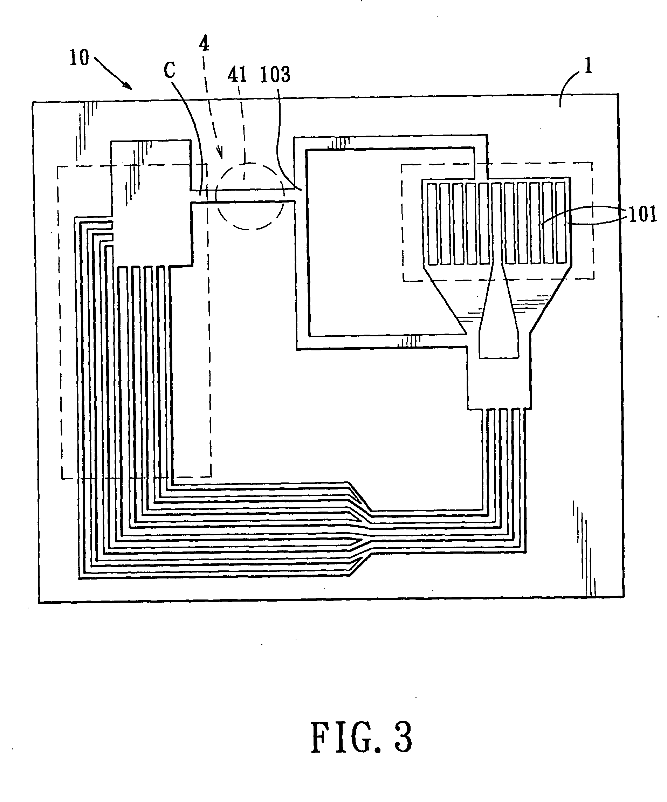

Figure 3 illustrates the second preferred embodiment of a heat dissipating microdevice according to the present invention. When compared with the previous preferred embodiment, the heat dissipating microdevice further comprises a flow controller 4. In this embodiment, the flow controller 4 includes a micro-driving member 41, such as a micro-pump, that is mounted on the board 1, that is in fluid communication with the first end section (c) of the first micro-conduit structure 103, and that is operable so as to induce flow of the coolant in the fluid microsystem 10. The construction as such permits flow of the coolant even before the coolant in the first micro-channel structure 101 is vaporized.

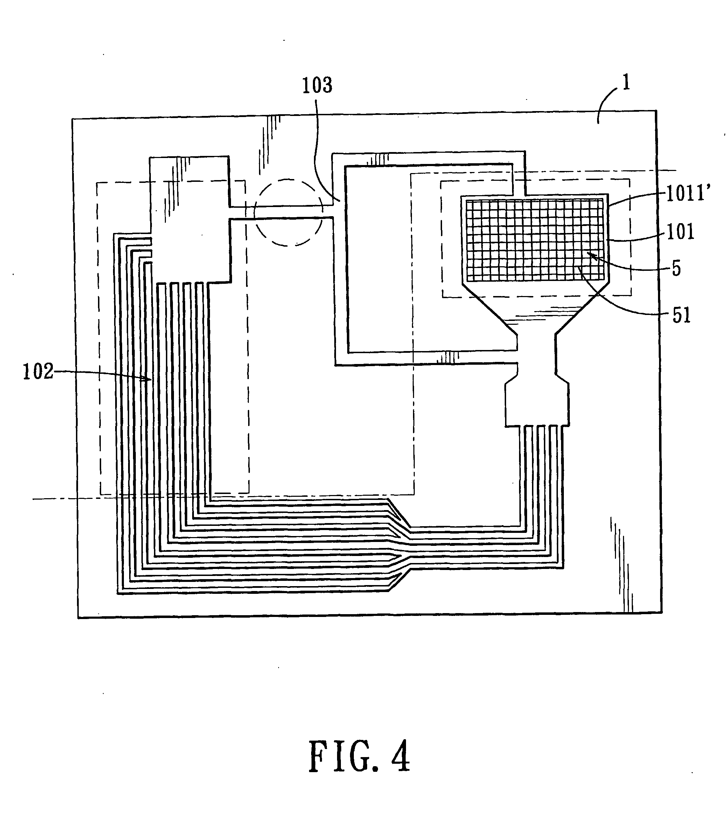

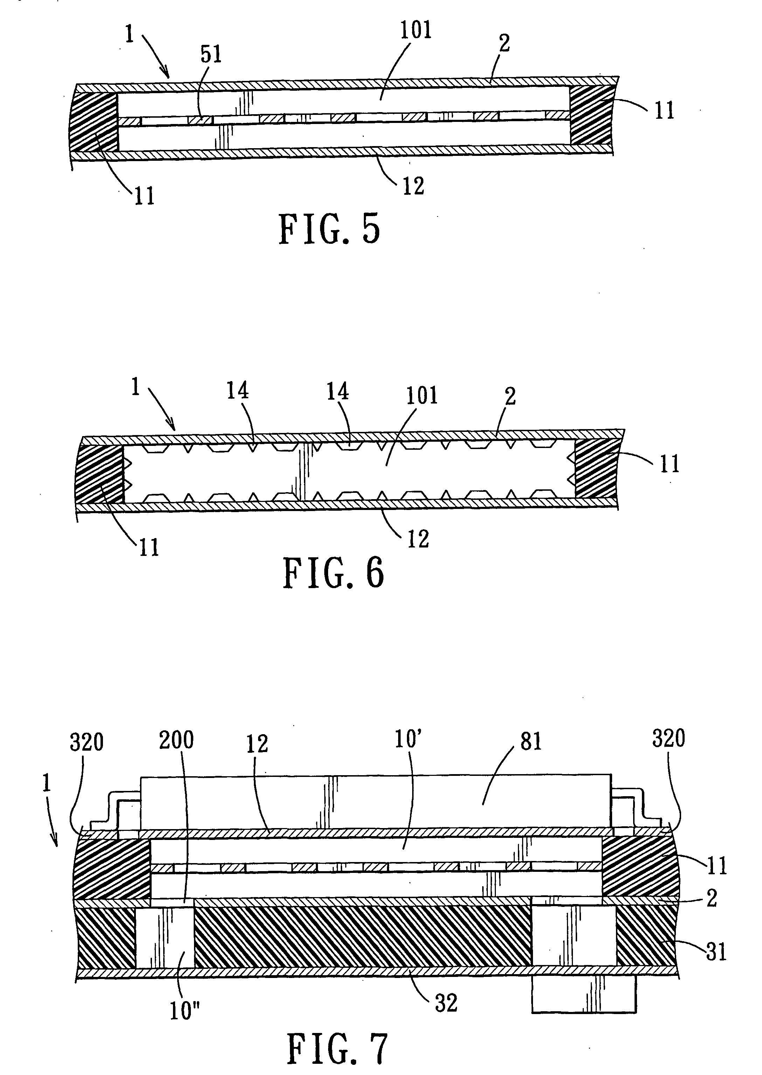

Figures 4 and 5 illustrate the third preferred embodiment of a heat dissipating microdevice according to the present invention. When compared with the previous preferred embodiment, the heat dissipating microdevice further comprises a micro-capillary member 5. The first micro-channel structure 101 includes only one channel 1011'. In this embodiment, the micro-capillary member 5 includes a metallic grid microstructure 51 that is disposed in the channel 1011' of the first micro-channel structure 101 and that provides a capillary action. As such, the flow of the coolant from the second micro-channel structure 102 to the first micro-channel structure 101 through the first micro-conduit structure 103 can be enhanced. In an alternative embodiment, with further reference to Figure 6, the micro-capillary member 5 includes a plurality of capillary protrusions 14 formed on the cover member 2, the first conductor layer 12, and the wall defining the channel 1011' of the first micro-channel structure 101.

With further reference to Figure 7, the fourth preferred embodiment of a heat dissipating microdevice according to the present invention is shown. When compared with the previous preferred embodiment, the board 1 further includes a second insulator layer 31 and a second conductor layer 32. The second insulator layer 31 has first and second surfaces, and is disposed on the cover member 2 such that the first surface of the second insulator layer 31 abuts against the cover member 2. The second conductor layer 32 is disposed on the second surface of the second insulator layer 31. In this embodiment, a part of the fluid microsystem 10, which is herein referred to as a primary fluid microsystem member 10' is formed in the first insulator layer 11, whereas another part of the fluid microsystem 10, which is herein referred to as a secondary fluid microsystem member 10", is formed in the second insulator layer 31. In this embodiment, with reference to Figure 1, the primary fluid microsystem member 10' includes the first micro-channel structure 101, the receiving microstructure 105, the mixing microstructure 106, and the second micro-conduit structure 104, whereas the secondary fluid microsystem member 10" includes the second micro-channel structure 102, the micro-reservoir structure 108, the first micro-conduit structure 103, and the third micro-conduit structure 107. The cover member 2 is formed with a communicating hole unit 200 so as to permit fluid communication between the first micro-channel structure 101 and the first micro-conduit structure 103, and between the second micro-channel structure 102 and the second micro-conduit structure 104 . Circuit traces 320 are formed on the first conductor layer 12. The integrated circuit 81 is electrically connected, such as by soldering, to the circuit traces 320.

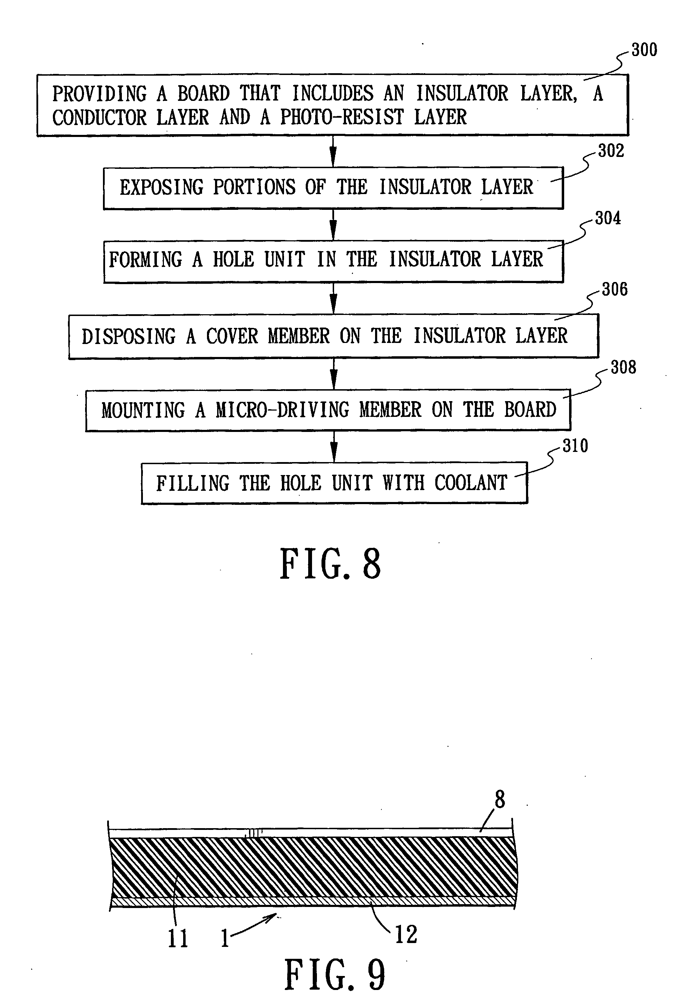

The preferred embodiment of a method for making the heat dissipating microdevice of Figure 3 includes the steps shown in Figure 8.

In step 300, with further reference to Figure 9, the board 1 is provided. The board 1 includes the insulator layer 11 that has the first surface and the second surface opposite to the first surface, the conductor layer 12 formed on the first surface of the insulator layer 11, and a photo-resist layer 8 coated on the second surface of the insulator layer 11.

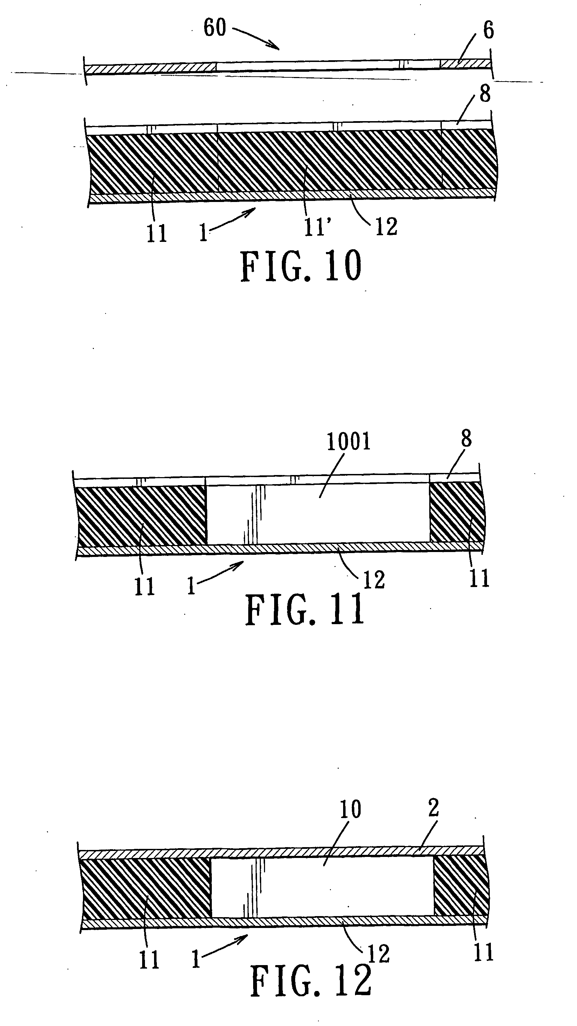

In step 302, with further reference to Figure 10, the photo-resist layer 8 is patterned to expose portions 11' of the second surface of the insulator layer 11. In this step, a photo-mask 6 is formed with a pattern 60 corresponding to the fluid microsystem 10 (see Figure 3) described hereinabove in connection with the second embodiment. The board 1 is subsequently exposed to radiation for transferring the pattern 60 on the photo-mask 6 to the photo-resist layer 8. A developing solution is used to form recesses in the photo-resist layer 8 corresponding to the pattern 60.

In step 304, with further reference to Figure 11, a hole unit 1001 is formed in the exposed portions 11' (see Figure 10) of the second surface of the insulator layer 11. The hole unit 1001 extends from the first surface to the second surface of the insulator layer 11 so as to result in the fluid microsystem bounded by the conductor layer 12. Preferably, the hole unit 1001 is formed by dry etching. Alternatively, the hole unit 1001 can be formed by wet etching or laser ablation.

In step 306, with further reference to Figure 12, the cover member 2 is disposed on the second surface of the insulator layer 11 to seal the fluid microsystem 10.

In step 308, the micro-driving member 41 (see Figure 3) is mounted on the board 1.

In step 310, the fluid microsystem 10 is filled with the coolant. The coolant is injected into the fluid microsystem 10 through the micro-driving member 41.

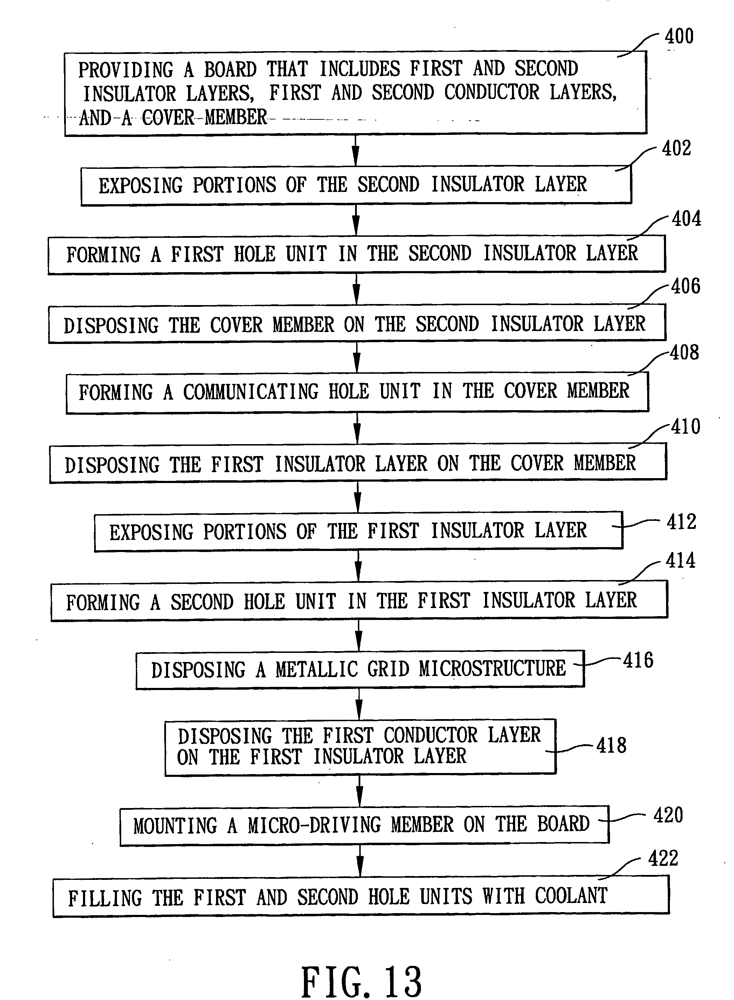

The preferred embodiment of a method for making the heat dissipating microdevice of Figure 7 includes the steps shown in Figure 13.

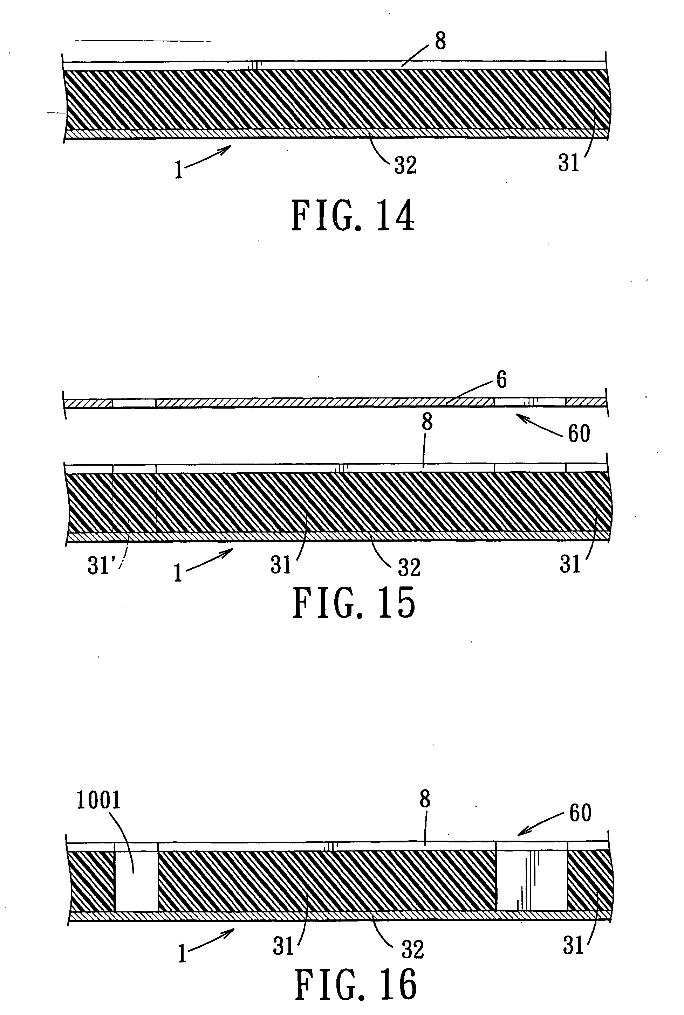

In step 400, with further reference to Figure 14, the board 1 is provided. The board 1 includes the first and second insulator layers 11,31, the first and second conductor layers 12, 32, and the cover member 2. Each of first and second insulator layers 11, 31 has the first surface and the second surface opposite to the first surface. The second conductor layer 32 is formed on the second surface of the second insulator layer 31, and a photo-resist layer 8 is coated on the first surface of the second insulator layer 31.

In step 402, with further reference to Figure 15, the photo-resist layer 8 is patterned to expose portions 31' of the first surface of the second insulator layer 31. In this step, a photo-mask 6 is formed with a pattern 60 corresponding to the secondary fluid microsystem 10" (see Figure 7) described hereinabove in connection with the fourth preferred embodiment. The board 1 is subsequently exposed to radiation for transferring the pattern 60 on the photo-mask 6 to the photo-resist layer 8. A developing solution is used to form recesses in the photo-resist layer 8 corresponding to the pattern 60.

In step 404, with further reference to Figure 16, a first hole unit 1001 is formed in the exposed portions 31' (see Figure 15) of the first surface of the second insulator layer 31. The first hole unit 1001 extends from the first surface to the second surface of the second insulator layer 31 so as to result in the secondary fluid microsystem bounded by the second conductor layer 32. Preferably, the first hole unit 1001 is formed by dry etching. Alternatively, the first hole unit 1001 can be formed by wet etching or laser ablation.

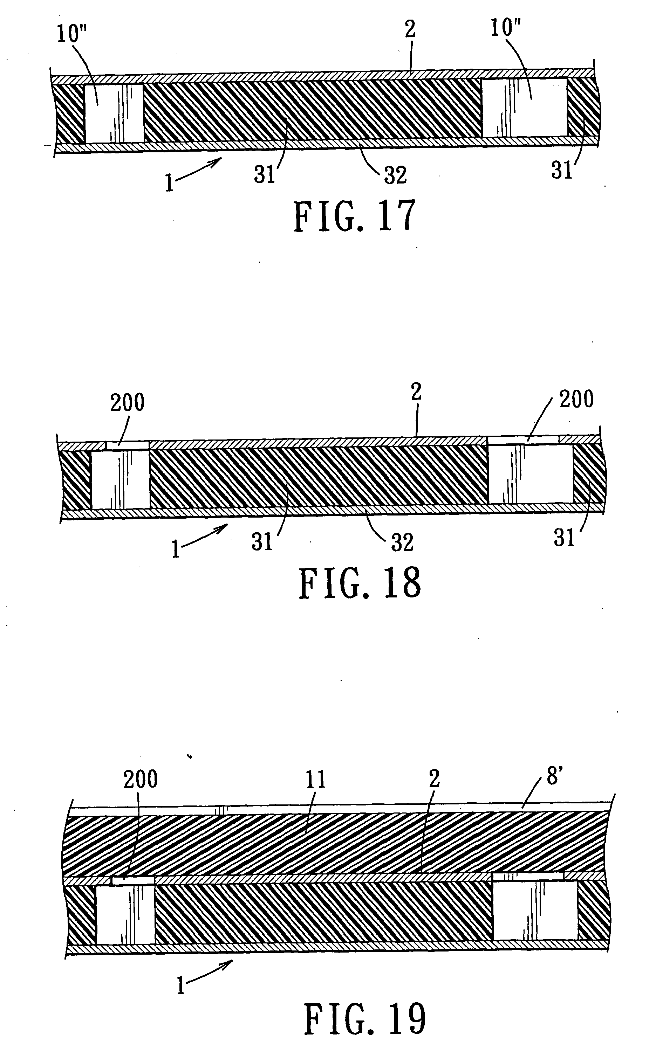

In step 406, with further reference to Figure 17, the cover member 2 is disposed on the first surface of the second insulator layer 31.

In step 408, with further reference to Figure 18, the communicating hole unit 200 is formed in the cover member 2.

In step 410, with further reference to Figure 19, the first insulator layer 11 is disposed on the cover member 2 such that the second surface of the first insulator layer 11 lies on the cover member 2. A photo-resist layer 8' is coated on the first surface of the first insulator layer 11.

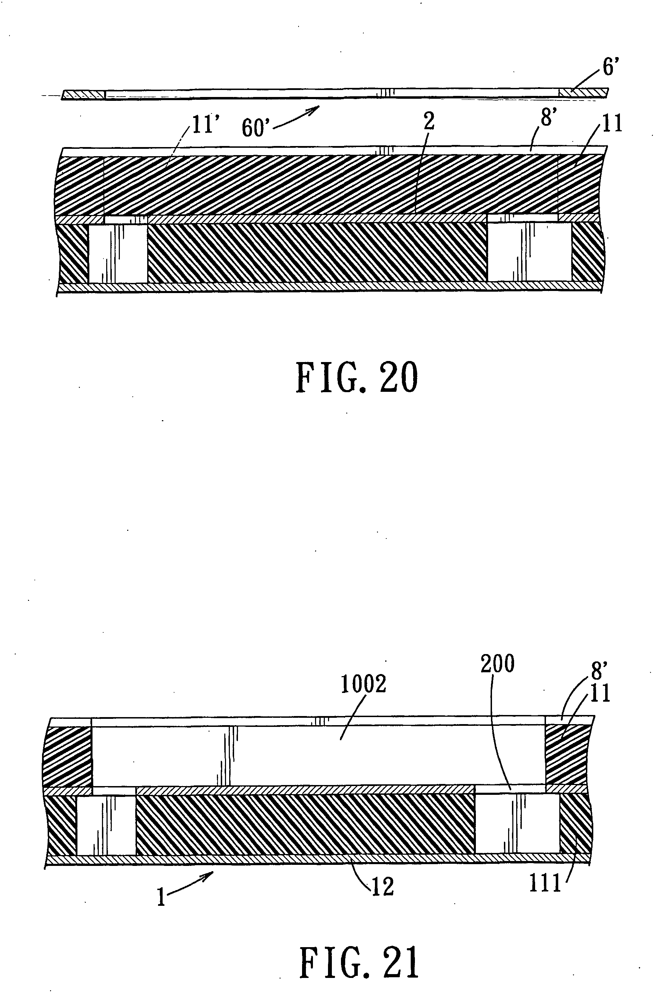

In step 412, with further reference to Figure 20, the photo-resist layer 8' is patterned to expose portions 11' of the first surface of the first insulator layer 11. In this step, a photo-mask 6' is formed with a pattern 60' that corresponds to the primary fluid microsystem 10' (see Figure 7) described hereinabove in connection with the fourth preferred embodiment. The board 1 is subsequently exposed to radiation for transferring the pattern 60' on the photo-mask 6' to the photo-resist layer 8'. A developing solution is used to form recesses in the photo-resist layer 8' corresponding to the pattern 60'.

In step 414, with further reference to Figure 21, a second hole unit 1002 is formed in the exposed portions 11' (see Figure 20) of the first surface of the first insulator layer 11. The second hole unit 1002 extends from the first surface to the second surface of the first insulator layer 11 so as to result in the primary fluid microsystem that is bounded by the cover member 2. Preferably, the second hole unit 1002 is formed by dry etching. Alternatively, the second hole unit 1002 can be formed by wet etching or laser ablation.

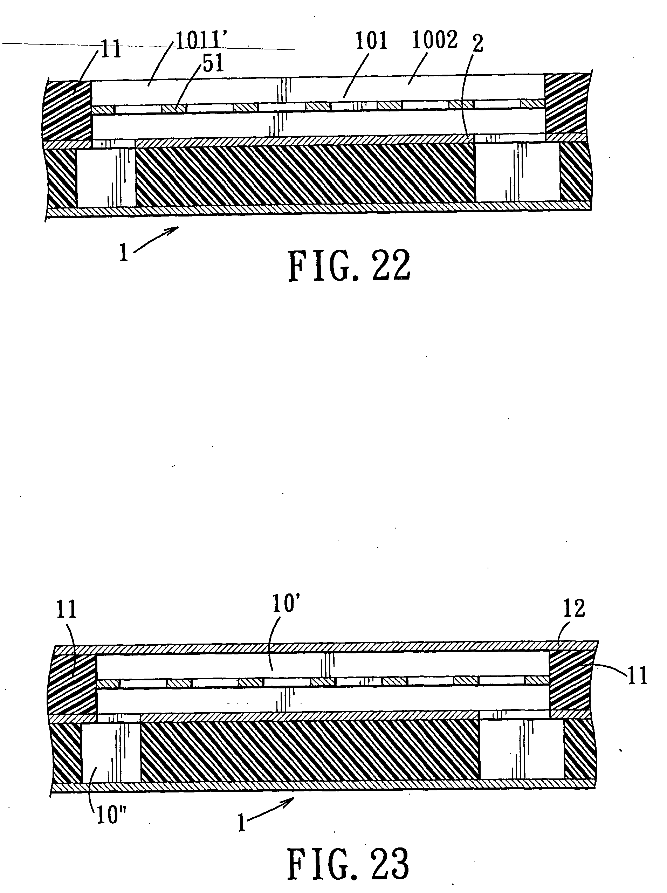

In step 416, with further reference to Figure 22, the metallic grid microstructure 51 is disposed in the channel 1011' of the first micro-channel structure 101. It is noted that, in the alternative embodiment, the capillary protrusions 14 (see Figure 5) are formed, such as by sintering, on the cover member 2 and the wall defining the channel 1011' of the first micro-channel structure 101.

In step 418, with further reference to Figure 23, the first conductor layer 12 is disposed on the first surface of the first insulator layer 11 to seal the fluid microsystem. In the alternative embodiment, the capillary protrusions 14 are formed on the first conductor layer 12 before disposing the latter on the first surface of the first insulator layer 11.

In step 420, a micro-driving member 41 (see Figure 3) is mounted on the board 1.

In step 422, the primary and secondary fluid microsystems 10', 10" are filled with a coolant. The coolant is injected into the primary and secondary fluid microsystems 10', 10" through the micro-driving member 41.

## Claims

1. A heat dissipating microdevice **characterized by**:
a board (1) including an insulator layer (11) that has a first surface and a second surface opposite to said first surface in a first direction, a conductor layer (12) formed on said first surface, and a cover member (2) disposed on said second surface, said board (1) having a first area (82) and a second area (83) opposite to said first area (82) in a second direction transverse to the first direction, said first area (82) being adapted to be placed in thermal contact with a heat source;
a fluid microsystem (10) formed in said insulator layer (11) of said board (1), and including
first and second micro-channel structures (101, 102) disposed respectively in said first and second areas (82), (83) of said board (1), at least one of said first and second micro-channel structures (101, 102) being bounded by at least one of said conductor layer (12) and said cover member (2),
first and second micro-conduit structures (103, 104) that permit fluid communication between said first and second micro-channel structures (101, 102), said first micro-conduit structure (103) including a first end section (c) in fluid communication with said second micro-channel structure (102) and a second end section (d) extending to and in fluid communication with said first micro-channel structure (101), said second micro-conduit structure (104) including a first end section (g) in fluid communication with said first micro-channel structure (101) and a second end section (h) extending to and in fluid communication with said second micro-channel structure (102), and
a receiving microstructure (105) that is disposed between and that permits fluid communication between said first micro-channel structure (101) and said second micro-conduit structure (104), that includes a first end portion (i) extending to and in fluid communication with said first micro-channel structure (101) and a second end portion (j) extending to and in fluid communication with said first end section (g) of said second micro-conduit structure (104), and that has a cross-section larger than those of said first micro-channel structure (101) and said second micro-conduit structure (104); and
a coolant contained in said fluid microsystem (10), said coolant flowing from said second micro-channel structure (102) to said first micro-channel structure (101) through said first micro-conduit structure (103), and from said first micro-channel structure (101) back to said second micro-channel structure (102) through said second micro-conduit structure (104) and said receiving microstructure (105).

2. The heat dissipating microdevice as claimed in Claim 1, **characterized in that** said first micro-channel structure (101) includes a plurality of parallel channels (1011), each of which includes first and second end portions (e, f),
said second end section (d) of said first micro-conduit structure (103) extending to said first end portions (e) of said channels (1011) of said first micro-channel structure (101),
said receiving microstructure (105) having a diverging section that serves as said first end portion (i) and a converging section that serves as said second end portion (j),
said second end portions (f) of said channels (1011) of said first micro-channel structure (101) extending to said diverging section of said receiving microstructure (105).

3. The heat dissipating microdevice as claimed in Claim 1, **characterized in that** said fluid microsystem (10) further includes
a mixing microstructure (106) that is disposed between and that permits fluid communication between said receiving microstructure (105) and said second micro-conduit structure (104), and that includes a first end portion (k) extending to and in fluid communication with said second end portion (j) of said receiving microstructure (105) and a second end portion (p) extending to and in fluid communication with said first end section (g) of said second micro-conduit structure (104), and
a third micro-conduit structure (107) that is disposed between and that permits fluid communication between said first micro-conduit structure (103) and said mixing microstructure (106), and that includes a first end portion (m) extending to said first end section (c) of said first micro-conduit structure (103) and a second end portion (n) extending to said mixing microstructure (106).

4. The heat dissipating microdevice as claimed in Claim 3, **characterized in that** said second end portion (n) of said third micro-conduit structure (107) extends to said first end portion (k) of said mixing microstructure (106).

5. The heat dissipating microdevice as claimed in Claim 3, **characterized in that** said first end section (g) of said second micro-conduit structure (104) includes a plurality of parallel first conduits (1041), each of which has first and second end portions (g1, g2),
said first end portions (g1) of said first conduits (1041) of said first end section (g) of said second micro-conduit structure (104) extending to and being in fluid communication with said second end portion (p) of said mixing microstructure (106),
said second end portions (g2) of said first conduits (1041) of said first end section (g) of said second micro-conduit structure (104) being bifurcated to form a pair of branches,
said second end section (h) of said second micro-conduit structure (104) including a plurality of parallel second conduits (1042), each of which extends from one of said branches of a respective one of said first conduits (1041).

6. The heat dissipating microdevice as claimed in Claim 5, **characterized in that** each of said first conduits (1041) has a cross-section larger than that of said second conduits (1042).

7. The heat dissipating microdevice as claimed in Claim 5, **characterized in that** said fluid microsystem (10) further includes a micro-reservoir structure (108) that is disposed between and that is in fluid communication with said second micro-channel structure (102) and said first micro-conduit structure (103).

8. The heat dissipating microdevice as claimed in Claim 7, **characterized in that** said micro-reservoir structure (108) has a cross-section larger than those of said second micro-channel structure (102) and said first micro-conduit structure (103).

9. The heat dissipating microdevice as claimed in Claim 7, **characterized in that** said second micro-channel structure (102) includes a plurality of parallel channels (1021), each of which extends between a respective one of said second conduits (1042) and said micro-reservoir structure (108).

10. The heat dissipating microdevice as claimed in Claim 1, **characterized in that** said fluid microsystem (10) further includes
a mixing microstructure (106) that is disposed between and that permits fluid communication between said first micro-channel structure (101) and said second micro-conduit structure (104), and
a third micro-conduit structure (107) that is disposed between and that permits fluid communication between said first micro-conduit structure (103) and said mixing microstructure (106), and that includes a first end portion (m) extending to said first end section (c) of said first micro-conduit structure (103) and a second end portion (n) extending to said mixing microstructure (106).

11. The heat dissipating microdevice as claimed in Claim 10, **characterized in that** said first end section (g) of said second micro-conduit structure (104) includes a plurality of parallel first conduits (1041), each of which has first and second end portions (g1, g2),
said first end portions (g1) of said first conduits (1041) of said first end section (g) of said second micro-conduit structure (104) extending to and being in fluid communication with said mixing microstructure (106),
said second end portions (g2) of said first conduits (1041) of said first end section (g) of said second micro-conduit structure (104) being bifurcated to form a pair of branches,
said second end section (h) of said second micro-conduit structure (104) including a plurality of parallel second conduits (1042), each of which extends from one of said branches of a respective one of said first conduits (1041).

12. The heat dissipating microdevice as claimed in Claim 1, **characterized in that** said fluid microsystem (10) further includes a micro-reservoir structure (108) that is disposed between and that is in fluid communication with said second micro-channel structure (102) and said first micro-conduit structure (103).

13. The heat dissipating microdevice as claimed in Claim 12, **characterized in that** said micro-reservoir structure (108) has a cross-section larger than those of said second micro-channel structure (102) and said first micro-conduit structure (103).

14. The heat dissipating microdevice as claimed in Claim 12, **characterized in that** said second micro-channel structure (102) includes a plurality of parallel channels (1021), each of which extends between said second micro-conduit structure (104) and said micro-reservoir structure (108).

15. The heat dissipating microdevice as claimed in Claim 1, further **characterized by** a flow controller (4) mounted on said board (1) and operable so as to induce flow of said coolant in said fluid microsystem (10).

16. The heat dissipating microdevice as claimed in Claim 15, **characterized in that** said flow controller (4) includes a micro-driving member (41) in fluid communication with said first micro-conduit structure (103) .

17. The heat dissipating microdevice as claimed in Claim 1, further **characterized by** a micro-capillary member (5) disposed in said first micro-channel structure (101) for providing capillary action.

18. The heat dissipating microdevice as claimed in Claim 17, **characterized in that** said micro-capillary member (5) includes one of a metallic grid microstructure (51) and a plurality of capillary protrusions (14) formed on at least one of said cover member (2) and said conductor layer (12).

19. The heat dissipating microdevice as claimed in Claim 1, **characterized in that** said coolant is one of methanol, acetone, and water.

20. A method of making a heat dissipating microdevice, **characterized by** the steps of:
(a) providing a board (1) that includes an insulator layer (11) having a first surface and a second surface opposite to the first surface, and a conductor layer (12) formed on the first surface of the insulator layer (11) ;
(b) forming a hole unit (1001) in said insulator layer (11) that extends from the first surface to the second surface of the insulator layer (11) to result in a fluid microsystem (10), the fluid microsystem (10) including
first and second micro-channel structures (101, 102) disposed respectively in first and second areas (82, 83) of the board (1) and bounded by the conductor layer (12),
first and second micro-conduit structures (103, 104) that permit fluid communication between the first and second micro-channel structures (101, 102), the first micro-conduit structure (103) including a first end section (c) in fluid communication with the second micro-channel structure (102) and a second end section (d) extending to and in fluid communication with the first micro-channel structure (101), the second micro-conduit structure (104) including a first end section (g) in fluid communication with the first micro-channel structure (101) and a second end section (h) extending to and in fluid communication with the second micro-channel structure (102), and
a receiving microstructure (105) that is disposed between and that permits fluid communication between the first micro-channel structure (101) and the second micro-conduit structure (104), that includes a first end portion (i) extending to and in fluid communication with the first micro-channel structure (101) and a second end portion (j) extending to and in fluid communication with the first end section (g) of the second micro-conduit structure (104), and that has a cross-section larger than those of the first micro-channel structure (101) and the second micro-conduit structure (104);
disposing a cover member (2) on the second surface of the insulator layer (11); and
(d) filling the fluid microsystem (10) with a coolant.

21. The method of Claim 20, wherein in step (a), the board (1) further includes a photo-resist layer (8) coated on the second surface of the insulator layer (11), and step (b) includes:
(b1) patterning the photo-resist layer (8) to expose portions (11') of the second surface of the insulator layer (11), and
(b2) forming the hole unit (1001) in the exposed portions (11') of the second surface of the insulator layer (11).

22. The method of Claim 20, further **characterized by** the step of disposing a metallic grid microstructure (51) in the hole unit (1001) prior to step (c).

23. The method of Claim 20, further **characterized by** the step of mounting of a micro-driving member (41) on said board (1) after step (c), the micro-driving member (41) being in fluid communication with the fluid microsystem (10).

24. The method of Claim 20, **characterized in that** the hole unit (1001) is formed in the insulator layer (11) by laser ablation.

25. The method of Claim 20, **characterized in that** the coolant is one of methanol, acetone, and water.

## Patentansprüche

1. Mikrovorrichtung zur Wärmeabfuhr, **gekennzeichnet durch**:
eine Baugruppe (1) mit einer Isolationsschicht (11), die eine erste Oberfläche und eine zweite Oberfläche gegenüber der ersten Oberfläche in einer ersten Richtung aufweist, einer Leiterschicht (12), die auf der ersten Oberfläche ausgebildet ist, und einem Abdeckelement (2), das auf der zweiten Oberfläche angeordnet ist, wobei die Baugruppe (1) einen ersten Bereich (82) und einen zweiten Bereich (83) gegenüber dem ersten Bereich (82) in einer zu der ersten Richtung quer laufenden zweiten Richtung aufweist, und wobei der erste Bereich (82) für eine Anordnung in thermischem Kontakt mit einer Wärmequelle eingerichtet ist;
ein Fluidmikrosystem (10), das in der Isolationsschicht (11) der Baugruppe (1) ausgebildet ist, und das versehen ist mit
einer ersten und einer zweiten Mikrokanalstruktur (101, 102), die in dem ersten bzw. in dem zweiten Bereich (82, 83) der Baugruppe (1) angeordnet sind, wobei zumindest die erste oder die zweite Mikrokanalstruktur (101, 102) **durch** zumindest die Leiterschicht (12) oder das Abdeckelement (2) begrenzt ist,
einer ersten und einer zweiten Mikroleitungsstruktur (103, 104), die eine Fluidkommunikation zwischen der ersten und der zweiten Mikrokanalstruktur (101, 102) erlauben, wobei die erste Mikroleitungsstruktur (103) einen ersten Endabschnitt (c) in Fluidkommunikation mit der zweiten Mikrokanalstruktur (102) und einen zweiten Endabschnitt (d) aufweist, der sich zu der ersten Mikrokanalstruktur (101) erstreckt und mit dieser in Fluidkommunikation steht, und wobei die zweite Mikroleitungsstruktur (104) einen ersten Endabschnitt (g) in Fluidkommunikation mit der ersten Mikrokanalstruktur (101) und einen zweiten Endabschnitt (h) aufweist, der sich zu der zweiten Mikrokanalstruktur (102) erstreckt und mit dieser in Fluidkommunikation steht, und
einer Empfangsmikrostruktur (105), die zwischen der ersten Mikrokanalstruktur (101) und der zweiten Mikroleitungsstruktur (104) angeordnet ist und eine Fluidkommunikation zwischen diesen erlaubt, die einen ersten Endabschnitt (i), der sich zu der ersten Mikrokanalstruktur (101) erstreckt und mit dieser in Fluidkommunikation steht, und einen zweiten Endabschnitt (j) beinhaltet, der sich zu dem ersten Endabschnitt (g) der zweiten Mikroleitungsstruktur (104) erstreckt und mit diesem in Fluidkommunikation steht, und die einen größeren Querschnitt als den der ersten Mikrokanalstruktur (101) und den der zweiten Mikroleitungsstruktur (104) aufweist; und
ein Kühlmittel, das in dem Fluidmikrosystem (10) enthalten ist, wobei das Kühlmittel von der zweiten Mikrokanalstruktur (102) zu der ersten Mikrokanalstruktur (101) **durch** die erste Mikroleitungsstruktur (103) sowie von der ersten Mikrokanalstruktur (101) zurück zu der zweiten Mikrokanalstruktur (102) **durch** die zweite Mikroleitungsstruktur (104) und die Empfangsmikrostruktur (105) fließt.

2. Mikrovorrichtung zur Wärmeabfuhr nach Anspruch 1, **dadurch gekennzeichnet, dass** die erste Mikrokanalstruktur (101) eine Vielzahl von parallelen Kanälen (1011) beinhaltet, von denen jeder einen ersten und einen zweiten Endabschnitt (e, f) beinhaltet,
der zweite Endabschnitt (d) der ersten Mikroleitungsstruktur (103) sich zu den ersten Endabschnitten (e) der Kanäle (1011) der ersten Mikrokanalstruktur (101) erstreckt,
die Empfangsmikrostruktur (105) einen Verzweigungsabschnitt, der als der erste Endabschnitt (i) dient, sowie einen Zusammenführungsabschnitt aufweist, der als der zweite Endabschnitt (j) dient, und
die zweiten Endabschnitte (f) der Kanäle (1011) der ersten Mikrokanalstruktur (101) sich zu dem Verzweigungsabschnitt der Empfangsmikrostruktur (105) erstrecken.

3. Mikrovorrichtung zur Wärmeabfuhr nach Anspruch 1, **dadurch gekennzeichnet, dass** das Fluidmikrosystem (10) ferner versehen ist mit
einer Mischmikrostruktur (106), die zwischen der Empfangsmikrostruktur (105) und der zweiten Mikroleitungsstruktur (104) angeordnet ist und eine Fluidkommunikation zwischen diesen erlaubt, und die einen ersten Endabschnitt (k), der sich zu dem zweiten Endabschnitt (j) der Empfangsmikrostruktur (105) erstreckt und mit dieser in Fluidkommunikation steht, sowie einen zweiten Endabschnitt (p) beinhaltet, der sich zu dem ersten Endabschnitt (g) der zweiten Mikroleitungsstruktur (104) erstreckt und mit diesem in Fluidkommunikation steht, und
einer dritten Mikroleitungsstruktur (107), die zwischen der ersten Mikroleitungsstruktur (103) und der Mischmikrostruktur (106) angeordnet ist und eine Fluidkommunikation zwischen diesen erlaubt, und die einen ersten Endabschnitt (m), der sich zu dem ersten Endabschnitt (c) der ersten Mikroleitungsstruktur (103) erstreckt, sowie einen zweiten Endabschnitt (n) beinhaltet, der sich zu der Mischstruktur (106) erstreckt.

4. Mikrovorrichtung zur Wärmeabfuhr nach Anspruch 3, **dadurch gekennzeichnet, dass** der zweite Endabschnitt (n) der dritten Mikroleitungsstruktur (107) sich zu dem ersten Endabschnitt (k) der Mischmikrostruktur (106) erstreckt.

5. Mikrovorrichtung zur Wärmeabfuhr nach Anspruch 3, **dadurch gekennzeichnet, dass** der erste Endabschnitt (g) der zweiten Mikroleitungsstruktur (104) eine Vielzahl von parallelen ersten Leitungen (1041) beinhaltet, von denen jede einen ersten und einen zweiten Endabschnitt (g1, g2) aufweist,
die ersten Endabschnitte (g1) der ersten Leitungen (1041) des ersten Endabschnitts (g) der zweiten Mikroleitungsstruktur (104) sich zu dem zweiten Endabschnitt (p) der Mischmikrostruktur (106) erstrecken und mit dieser in Fluidkommunikation stehen,
die zweiten Endabschnitte (g2) der ersten Leitungen (1041) des ersten Endabschnitts (g) der zweiten Mikroleitungsstruktur (104) sich gabelförmig teilen, um ein Paar Verzweigungen auszubilden, und
der zweite Endabschnitt (h) der zweiten Mikroleitungsstruktur (104) eine Vielzahl von parallelen zweiten Leitungen (1042) beinhaltet, von denen sich jede von einer der Verzweigungen einer jeweiligen der ersten Leitungen (1041) erstreckt.

6. Mikrovorrichtung zur Wärmeabfuhr nach Anspruch 5, **dadurch gekennzeichnet, dass** jede der ersten Leitungen (1041) einen größeren Querschnitt als den der zweiten Leitungen (1042) aufweist.

7. Mikrovorrichtung zur Wärmeabfuhr nach Anspruch 5, **dadurch gekennzeichnet, dass** das Fluidmikrosystem (10) ferner eine Mikroreservoirstruktur (108) beinhaltet, die zwischen der zweiten Mikrokanalstruktur (102) und der ersten Mikroleitungsstruktur (103) angeordnet ist und mit diesen in Fluidkommunikation steht.

8. Mikrovorrichtung zur Wärmeabfuhr nach Anspruch 7, **dadurch gekennzeichnet, dass** die Mikroreservoirstruktur (108) einen größeren Querschnitt als den der zweiten Mikrokanalstruktur (102) und den der ersten Mikroleitungsstruktur (103) aufweist.

9. Mikrovorrichtung zur Wärmeabfuhr nach Anspruch 7, **dadurch gekennzeichnet, dass** die zweite Mikrokanalstruktur (102) eine Vielzahl von parallelen Kanälen (1021) beinhaltet, von denen sich jeder zwischen einer jeweiligen der zweiten Leitungen (1042) und der Mikroreservoirstruktur (108) erstreckt.

10. Mikrovorrichtung zur Wärmeabfuhr nach Anspruch 1, **dadurch gekennzeichnet, dass** das Fluidmikrosystem (10) ferner versehen ist mit
einer Mischmikrostruktur (106), die zwischen der ersten Mikrokanalstruktur (101) und der zweiten Mikroleitungsstruktur (104) angeordnet ist und eine Fluidkommunikation zwischen diesen erlaubt, und
einer dritten Mikroleitungsstruktur (107), die zwischen der ersten Mikroleitungsstruktur (103) und der Mischmikrostruktur (106) angeordnet ist und eine Fluidkommunikation zwischen diesen erlaubt, und die einen ersten Endabschnitt (m), der sich zu dem ersten Endabschnitt (c) der ersten Mikroleitungsstruktur (103) erstreckt, und einen zweiten Endabschnitt (n) aufweist, der sich zu der Mischmikrostruktur (106) erstreckt.

11. Mikrovorrichtung zur Wärmeabfuhr nach Anspruch 10, **dadurch gekennzeichnet, dass** der erste Endabschnitt (g) der zweiten Mikroleitungsstruktur (104) eine Vielzahl von parallelen ersten Leitungen (1041) beinhaltet, von denen jede einen ersten und einen zweiten Endabschnitt (g1, g2) aufweist,
die ersten Endabschnitte (g1) der ersten Leitungen (1041) des ersten Endabschnitts (g) der zweiten Mikroleitungsstruktur (104) sich zu der Mischmikrostruktur (106) erstrecken und mit dieser in Fluidkommunikation stehen,
die zweiten Endabschnitte (g2) der ersten Leitungen (1041) des ersten Endabschnitts (g) der zweiten Mikroleitungsstruktur (104) sich gabelförmig teilen, um ein Paar Verzweigungen auszubilden, und
der zweite Endabschnitt (h) der zweiten Mikroleitungsstruktur (104) eine Vielzahl von parallelen zweiten Leitungen (1042) beinhaltet, von denen sich jede von einer der Verzweigungen einer jeweiligen der ersten Leitungen (1041) erstreckt.

12. Mikrovorrichtung zur Wärmeabfuhr nach Anspruch 1, **dadurch gekennzeichnet, dass** das Fluidmikrosystem (10) ferner eine Mikroreservoirstruktur (108) beinhaltet, die zwischen der zweiten Mikrokanalstruktur (102) und der ersten Mikroleitungsstruktur (103) angeordnet ist, und mit diesen in Fluidkommunikation steht.

13. Mikrovorrichtung zur Wärmeabfuhr nach Anspruch 12, **dadurch gekennzeichnet, dass** die Mikroreservoirstruktur (108) einen größeren Querschnitt als den der zweiten Mikrokanalstruktur (102) und den der ersten Mikroleitungsstruktur (103) aufweist.

14. Mikrovorrichtung zur Wärmeabfuhr nach Anspruch 12, **dadurch gekennzeichnet, dass** die zweite Mikrokanalstruktur (102) eine Vielzahl von parallelen Kanälen (1021) beinhaltet, von denen sich jeder zwischen der zweiten Mikroleitungsstruktur (104) und der Mikroreservoirstruktur (108) erstreckt.

15. Mikrovorrichtung zur Wärmeabfuhr nach Anspruch 1, ferner **gekennzeichnet durch** eine auf der Baugruppe (1) befestigte Durchflussreglereinrichtung (4), die zum Induzieren des Flusses des Kühlmittels in dem Fluidmikrosystem (10) eingerichtet ist.

16. Mikrovorrichtung zur Wärmeabfuhr nach Anspruch 15, **dadurch gekennzeichnet, dass** die Durchflussreglereinrichtung (4) ein Mikroansteuerungselement (41) beinhaltet, das in Fluidkommunikation mit der ersten Mikroleitungsstruktur (103) steht.

17. Mikrovorrichtung zur Wärmeabfuhr nach Anspruch 1, ferner **gekennzeichnet durch** ein Mikrokapillarelement (5), das in der ersten Mikrokanalstruktur (101) zur Bereitstellung einer Kapillarwirkung angeordnet ist.

18. Mikrovorrichtung zur Wärmeabfuhr nach Anspruch 17, **dadurch gekennzeichnet, dass** das Mikrokapillarelement (5) eine metallische Netzmikrostruktur (51) oder eine Vielzahl von zumindest auf dem Abdeckelement (2) oder der Leiterschicht (12) ausgebildeten Kapillarvorsprünge beinhaltet.

19. Mikrovorrichtung zur Wärmeabfuhr nach Anspruch 1, **dadurch gekennzeichnet, dass** das Kühlmittel Methanol, Aceton oder Wasser ist.

20. Verfahren zur Herstellung einer Mikrovorrichtung zur Wärmeabfuhr, **gekennzeichnet durch** die Schritte:
(a) Bereitstellen einer Baugruppe (1), die eine Isolatorschicht (11) mit einer ersten Oberfläche und einer der ersten Oberfläche gegenüberliegenden zweiten Oberfläche sowie eine auf der ersten Oberfläche der Isolatorschicht (11) ausgebildete Leiterschicht (12) beinhaltet;
(b) Ausbilden einer Locheinheit (1001) in der Isolatorschicht (11), die sich von der ersten Oberfläche zu der zweiten Oberfläche der Isolatorschicht (11) erstreckt, damit sich ein Fluidmikrosystem (10) ergibt, wobei das Fluidmikrosystem (10) versehen ist mit
einer ersten und einer zweiten Mikrokanalstruktur (101, 102), die in einem ersten bzw. zweiten Bereich (82, 83) der Baugruppe (1) angeordnet und **durch** die Leiterschicht (12) begrenzt sind,
einer ersten und einer zweiten Mikroleitungsstruktur (103, 104), die eine Fluidkommunikation zwischen der ersten und der zweiten Mikrokanalstruktur (101, 102) erlauben, wobei die erste Mikroleitungsstruktur (103) einen ersten Endabschnitt (c) in Fluidkommunikation mit der zweiten Mikrokanalstruktur (102) sowie einen zweiten Endabschnitt (d) aufweist, der sich zu der ersten Mikrokanalstruktur (101) erstreckt und mit dieser in Fluidkommunikation steht, und wobei die zweite Mikroleitungsstruktur (104) einen ersten Endabschnitt (g) in Fluidkommunikation mit der ersten Mikrokanalstruktur (101) und einen zweiten Endabschnitt (h) beinhaltet, der sich zu der zweiten Mikrokanalstruktur (102) erstreckt und mit dieser in Fluidkommunikation steht, und
einer Empfangsmikrostruktur (105), die zwischen der ersten Mikrokanalstruktur (101) und der zweiten Mikroleitungsstruktur (104) angeordnet ist und eine Fluidkommunikation zwischen diesen erlaubt, die einen ersten Endabschnitt (i), der sich zu der ersten Mikrokanalstruktur (101) erstreckt und mit dieser in Fluidkommunikation steht, und einen zweiten Endabschnitt (j) beinhaltet, der sich zu dem ersten Endabschnitt (g) der zweiten Mikroleitungsstruktur (104) erstreck, und mit diesem in Fluidkommunikation steht, und die einen größeren Querschnitt als den der ersten Mikrokanalstruktur (101) und den der zweiten Mikroleitungsstruktur (104) aufweist;
(c) Anordnen eines Abdeckelementes (2) auf der zweiten Oberfläche der Isolatorschicht (11); und
(d) Füllen des Fluidmikrosystems (c) mit einem Kühlmittel.

21. Verfahren nach Anspruch 20, wobei bei Schritt (a) die Baugruppe (1) ferner eine auf der zweiten Oberfläche der Isolatorschicht (11) beschichtete Fotoresistlackschicht (8) beinhaltet, und Schritt (b) versehen ist mit:
(b1) Strukturieren der Fotoresistlackschicht (8) zum Freilegen von Abschnitten (11') der zweiten Oberfläche der Isolatorschicht (11), und
(b2) Ausbilden der Locheinheit (1001) in den freigelegten Abschnitten (11') der zweiten Oberfläche der Isolatorschicht (11).

22. Verfahren nach Anspruch 20, ferner **gekennzeichnet durch** den Schritt Anordnen einer metallischen Netzmikrostruktur (51) in der Locheinheit (1001) vor Schritt (c).

23. Verfahren nach Anspruch 20, ferner **gekennzeichnet, durch** den Schritt Befestigen eines Mikroansteuerungselementes (41) auf der Baugruppe (1) nach Schritt (c), wobei das Mikroansteuerungselement (41) in Fluidkommunikation mit dem Fluidmikrosystem (10) steht.

24. Verfahren nach Anspruch 20, **dadurch gekennzeichnet, dass** die Locheinheit (1001) in der Isolatorschicht (11) durch Laserabtragung ausgebildet wird.

25. Verfahren nach Anspruch 20, **dadurch gekennzeichnet, dass** das Kühlmittel Methanol, Aceton oder Wasser ist.

## Revendications

1. Micro-dispositif de dissipation thermique **caractérisé par**
une carte (1) comprenant une couche isolante (11) qui a une première surface et une seconde surface opposée à ladite première surface dans une première direction, une couche conductrice (12) formée sur ladite première surface, et un élément de protection (2) disposé sur ladite seconde surface, ladite carte (1) ayant une première zone (82) et une seconde zone (83) opposée à ladite première zone (82) dans une seconde direction transversale à la première direction, ladite première zone (82) étant adaptée pour être placée en contact thermique avec une source de chaleur ;
un microsystème fluide (10) formé dans ladite couche isolante (11) de ladite carte (1), et comprenant
des première et seconde microstructures de canaux (101, 102) disposées respectivement dans lesdites première et seconde zones (82), (83) de ladite carte (1), au moins l'une desdites première et seconde microstructures de canaux (101, 102) étant bordée par au moins l'un parmi ladite couche conductrice (12) et ledit élément de protection (2),
des première et seconde microstructures de conduits (103, 104) qui permettent la communication par écoulement entre lesdites première et seconde microstructures de canaux (101, 102), ladite première microstructure de conduits (103) comprenant une première section d'extrémité (c) en communication par écoulement avec ladite seconde microstructure de canaux (102) et une seconde section d'extrémité (d) s'étendant vers et en communication par écoulement avec ladite première microstructure de canaux (101), ladite seconde microstructure de conduits (104) comprenant une première section d'extrémité (g) en communication par écoulement avec ladite première microstructure de canaux (101) et une seconde section d'extrémité (h) s'étendant vers et en communication par écoulement avec ladite seconde microstructure de canaux (102), et
un microstructure de réception (105) qui est disposée entre qui permet la communication par écoulement entre ladite première microstructure de canaux (101) et ladite seconde microstructure de conduits (104), qui comprend une première partie d'extrémité (i) s'étendant vers et en communication par écoulement avec ladite première microstructure de canaux (101) et une seconde partie d'extrémité (j) s'étendant vers et en communication par écoulement avec ladite première section d'extrémité (g) de ladite seconde microstructure de conduits (104), et qui a une section transversale plus grande que celle de ladite première microstructure de canaux (101) et ladite seconde microstructure de conduits (104) ; et
un réfrigérant contenu dans ledit microsystème fluide (10), ledit réfrigérant s'écoulant depuis ladite seconde microstructure de canaux (102) vers ladite première microstructure de canaux (101) à travers ladite première microstructure de conduits (103), et depuis ladite première microstructure de canaux (101) retourne vers ladite seconde microstructure de canaux (102) à travers ladite seconde microstructure de conduits (104) et ladite microstructure de réception (105).

2. Micro-dispositif de dissipation thermique selon la revendication 1, **caractérisé en ce que** ladite première microstructure de canaux (101) comprend une pluralité de canaux parallèles (1011) qui comprennent chacun des première et seconde extrémités (e, f),
ladite seconde section d'extrémité (d) de ladite première microstructure de conduits (103) s'étendant vers ladite première section d'extrémité (e) desdits canaux (1011) de ladite première microstructure de canaux (101),
ladite microstructure de réception (105) ayant une section divergente qui sert comme ladite première partie d'extrémité (i) et une section convergente qui sert comme ladite seconde partie d'extrémité (j),
lesdites secondes parties d'extrémité (f) desdits canaux (1011) de ladite première microstructure de canaux (101) s'étendant vers ladite section divergente de ladite microstructure de réception (105).

3. Micro-dispositif de dissipation thermique selon la revendication 1, **caractérisé en ce que** ledit microsystème fluide (10) comprend en outre :
une microstructure de mélange (106) qui est disposée entre et qui permet la communication par écoulement entre ladite microstructure de réception (105) et ladite seconde microstructure de conduits (104), et qui comprend une première partie d'extrémité (k) s'étendant vers et en communication par écoulement avec ladite seconde partie d'extrémité (j) de ladite microstructure de réception (105) et une seconde partie d'extrémité (p) s'étendant vers et en communication par écoulement avec ladite première section d'extrémité (g) de ladite seconde microstructure de conduits (104), et
une troisième microstructure de conduits (107) qui est disposée entre et qui permet la communication par écoulement entre ladite première microstructure de conduits (103) et ladite microstructure de mélange (106), et qui comprend une première partie d'extrémité (m) s'étendant vers ladite première section d'extrémité (c) de ladite première microstructure de conduits (103) et une seconde partie d'extrémité (n) s'étendant vers ladite microstructure de mélange (106).

4. Micro-dispositif de dissipation thermique selon la revendication 3, **caractérisé en ce que** ladite seconde partie d'extrémité (n) de ladite troisième microstructure de conduits (107) s'étend vers ladite première partie d'extrémité (k) de ladite microstructure de mélange (106).

5. Micro-dispositif de dissipation thermique selon la revendication 3, **caractérisé en ce que** ladite première section d'extrémité (g) de ladite seconde microstructure de conduits (104) comprend une pluralité de premiers conduits (1041) parallèles, qui ont chacun une première et une seconde parties d'extrémité (g1, g2),
lesdites premières parties d'extrémité (g1) desdits premiers conduits (1041) de ladite première section d'extrémité (g) de ladite seconde microstructure de conduits (104) s'étendant vers et étant en communication par écoulement avec ladite seconde partie d'extrémité (p) de ladite microstructure de mélange (106),
lesdites secondes parties d'extrémité (g2) desdits premiers conduits (1041) de ladite première section d'extrémité (g) de ladite seconde microstructure de conduits (104) bifurquant pour former une paire de branches,
ladite seconde section d'extrémité (h) de ladite seconde microstructure de conduits (104) comprenant une pluralité de seconds conduits (1042) parallèles, qui s'étendent chacun depuis l'une desdites branches de l'un respectif des premiers conduits (1041).

6. Micro-dispositif de dissipation thermique selon la revendication 5, **caractérisé en ce que** chacun desdits premiers conduits (1041) a une section transversale plus grande que celle desdits seconds conduits (1042).

7. Micro-dispositif de dissipation thermique selon la revendication 5, **caractérisé en ce que** ledit microsystème fluide (10) comprend en outre une structure de microréservoirs (108) qui est disposée entre et qui est en communication par écoulement avec ladite seconde microstructure de canaux (102) et ladite première microstructure de conduits (103).

8. Micro-dispositif de dissipation thermique selon la revendication 7, **caractérisé en ce que** ladite structure de microréservoirs (108) a une section transversale plus grande que celle de ladite seconde microstructure de canaux (102) et ladite première microstructure de conduits (103).

9. Micro-dispositif de dissipation thermique selon la revendication 7, **caractérisé en ce que** ladite seconde microstructure de canaux (102) comprend une pluralité de canaux (1021) parallèles, qui s'étendent chacun entre l'un respectif desdits conduits (1042) et ladite structure de microréservoirs (108).

10. Micro-dispositif de dissipation thermique selon la revendication 1, **caractérisé en ce que** ledit microsystème fluide (10) comprend en outre :
une microstructure de mélange (106) qui est disposée entre et qui permet la communication par écoulement entre ladite première microstructure de canaux (101) et ladite seconde microstructure de conduits (104), et
une troisième microstructure de conduits (107) qui est disposée entre et qui permet la communication par écoulement entre ladite première microstructure de conduits (103) et ladite microstructure de mélange (106), et qui comprend une première partie d'extrémité (m) s'étendant jusqu'à ladite première section d'extrémité (c) de ladite première microstructure de conduits (103) et une seconde partie d'extrémité (n) s'étendant vers ladite microstructure de mélange (106).

11. Micro-dispositif de dissipation thermique selon la revendication 10, **caractérisé en ce que** ladite première section d'extrémité (g) de ladite seconde microstructure de conduits (104) comprend une pluralité de premiers conduits (1041) parallèles, qui ont chacun une première et une seconde parties d'extrémité (g1, g2),
lesdites premières parties d'extrémité (g1) desdits premiers conduits (1041) de ladite première section d'extrémité (g) de ladite seconde microstructure de conduits (104) s'étendant vers et étant en communication par écoulement avec ladite microstructure de mélange (106),
lesdites secondes parties d'extrémité (g2) desdits premiers conduits (1041) de ladite première section d'extrémité (g) de ladite seconde microstructure de conduits (104) bifurquant pour former une paire de branches,
ladite seconde section d'extrémité (h) de ladite seconde microstructure de conduits (104) comprenant une pluralité de seconds conduits (1042) parallèles, qui s'étendent chacun depuis l'une des branches de l'un respectif des premiers conduits (1041).

12. Micro-dispositif de dissipation thermique selon la revendication 1, **caractérisé en ce que** ledit microsystème fluide (10) comprend en outre une structure de microréservoirs (108) qui est disposée entre et qui est en communication par écoulement avec ladite seconde microstructure de canaux (102) et ladite première microstructure de conduits (103).

13. Micro-dispositif de dissipation thermique selon la revendication 12, **caractérisé en ce que** ladite structure de microréservoirs (108) a une section transversale plus grande que celle de ladite seconde microstructure de canaux (102) et ladite première microstructure de conduits (103).

14. Micro-dispositif de dissipation thermique selon la revendication 12, **caractérisé en ce que** ladite seconde microstructure de canaux (102) comprend une pluralité de canaux (1021) parallèles, qui s'étendent chacun entre ladite seconde microstructure de conduits (104) et ladite structure de microréservoirs (108).

15. Micro-dispositif de dissipation thermique selon la revendication 1, **caractérisé en outre par** une commande d'écoulement (4) montée sur ladite carte (1) et pouvant fonctionner de façon à induire un écoulement dudit réfrigérant dans ledit microsystème fluide (10).

16. Micro-dispositif de dissipation thermique selon la revendication 15, **caractérisé en ce que** ladite commande d'écoulement (4) comprend un micro-élément d'entraînement (41) en communication par écoulement avec ladite première microstructure de conduits (103).

17. Micro-dispositif de dissipation thermique selon la revendication 1, **caractérisé en outre par** une micro-élément capillaire (5) disposé dans ladite première microstructure de canaux (101) pour fournir une action capillaire.

18. Micro-dispositif de dissipation thermique selon la revendication 17, **caractérisé en ce que** ledit micro-élément capillaire (5) comprend l'une parmi une microstructure de grille métallique (51) et une pluralité de saillies capillaires (14) formée sur au moins l'un dudit élément de protection (2) et de ladite couche conductrice (12).

19. Micro-dispositif de dissipation thermique selon la revendication 1, **caractérisé en ce que** ledit réfrigérant est l'un parmi le méthanol, l'acétone, et l'eau.

20. Procédé pour faire un micro-dispositif de dissipation thermique, **caractérisé par** les étapes consistant à :
(a) fournir une carte (1) qui comprend une couche isolante (11) ayant une première surface et une seconde surface opposée à la premier surface, et une couche conductrice (12) formée sur la première surface de la couche isolante (11) ;
(b) former une unité de trou (1001) dans ladite couche isolante (11) qui s'étend depuis la première surface jusqu'à la seconde surface de la couche isolante (11) pour donner un microsystème fluide (10), le microsystème fluide (10) comprenant
des première et seconde microstructures de canaux (101, 102) disposées respectivement dans les première et seconde zones (82, 83) du panneau (1) et bordées par la couche conductrice (12),
des première et seconde microstructures de conduits (103, 104) qui permettent une communication par écoulement entre les première et seconde microstructures de canaux (101, 102), la première microstructure de conduits (103) comprenant une première section (c) en communication par écoulement avec la seconde microstructure de canaux (102) et une seconde section d'extrémité (d) s'étendant vers et en communication par écoulement avec la première microstructure de canaux (101), la seconde microstructure de conduits (104) comprenant une première section d'extrémité (g) en communication par écoulement avec la première microstructure de canaux (101) et une seconde section d'extrémité (h) s'étendant jusqu'à et en communication par écoulement avec la seconde microstructure de canaux (102), et
une microstructure de réception (105) qui est disposée entre et qui permet la communication par écoulement entre la première microstructure de canaux (101) et la seconde microstructure de conduits (104), qui comprend une première partie d'extrémité (i) s'étendant jusqu'à et en communication par écoulement avec la première microstructure de canaux (101) et une seconde partie d'extrémité (j) s'étendant jusqu'à et en communication par écoulement avec la première section d'extrémité (g) de la seconde microstructure de conduits (104), et qui a une section transversale plus grande que celles de la première microstructure de canaux (101) et la seconde microstructure de conduits (104) ;
disposer un élément de protection (2) sur la seconde surface de la couche isolante (11) ; et
(d) remplir le microsystème fluide (10) avec un réfrigérant.

21. Procédé selon la revendication 20, dans lequel lors de l'étape (a), la carte (1) comprend en outre une couche photorésistante (8) déposée sur la seconde surface de la couche isolante (11), et l'étape (b) comprend :
(b1) de dessiner la couche photorésistante (8) pour exposer des parties (11') de la seconde surface de la couche isolante (11), et
(b2) former l'unité de trou (1001) dans les parties exposées (11') de la seconde surface de la couche isolante (11).

22. Procédé selon la revendication 20, **caractérisé en outre par** l'étape consistant à déposer une microstructure en grille métalliques (51) dans l'unité de trou (1001) avant l'étape (c).

23. Procédé selon la revendication 20, **caractérisée en outre par** l'étape consistant à monter un micro-élément d'entraînement (41) sur ledit panneau (1) après l'étape (c), le micro-élément d'entraînement (41) étant en communication par écoulement avec le microsystème fluide (10).

24. Procédé selon la revendication 20, **caractérisé en ce que** l'unité de trou (1001) est formée dans la couche isolante (11) par ablation laser.

25. Procédé selon la revendication 20, **caractérisé en ce que** le réfrigérant est l'un parmi le méthanol, l'acétone, et l'eau.
